(19) Europäisches Patentamt

European Patent Office

Office européen des brevets

(11) **EP 1 360 773 B1**

(12) **EUROPEAN PATENT SPECIFICATION**

(45) Date of publication and mention
of the grant of the patent:
**20.07.2005 Bulletin 2005/29**

(21) Application number: **01270015.9**

(22) Date of filing: **03.12.2001**

(51) Int Cl.7: **H04B 1/10**, H03G 3/20

(86) International application number:
**PCT/GB2001/005335**

(87) International publication number:
**WO 2002/047258 (13.06.2002 Gazette 2002/24)**

(54) **SIGNAL PROCESSING**

SIGNALVERARBEITUNG

TRAITEMENT DE SIGNAL

(84) Designated Contracting States:
**AT BE CH CY DE DK ES FI FR GB GR IE IT LI LU
MC NL PT SE TR**

(30) Priority: **07.12.2000 GB 0029874**

(43) Date of publication of application:
**12.11.2003 Bulletin 2003/46**

(73) Proprietor: **Ubinetics Limited
Melbourn, Hertfordshire SG8 6DP (GB)**

(72) Inventor: **THURSTON, Andrew
Cambridge CB3 0QG (GB)**

(74) Representative: **Gillard, Matthew Paul
Withers & Rogers LLP
Goldings House,
2 Hays Lane
London SE1 2HW (GB)**

(56) References cited:
EP-A- 0 901 239          WO-A-91/05415
WO-A-97/09790          WO-A-99/54996

**Description**

The invention relates to signal processing, and in particular to methods and apparatus for filtering digital signals that have been produced under variable gain conditions.

It is known to amplify a received signal under variable gain conditions. For example, it is known to use automatic gain control (AGC) in a receiver for the purpose of amplifying a received signal which is fading. A problem is that subsequent signal processing performed on the amplified signal is complicated by the fact that the gain used in the amplification is variable. It is an aim of the present invention to provide simpler signal processing of such signals.

In WO 97/09790, tap coefficients in a digital filter are recalculated when an AGC loop adjusts the gain applied upstream from the filter. In WO 99/54996, filter coefficients are scaled to minimise the bit-width required for multipliers in a digital filter.

According to one aspect, the invention provides signal processing apparatus for operating on a signal that has been amplified under variable gain, the apparatus comprising a digital filter for filtering the signal values and adapting means for adapting, when the gain changes, at least one signal value on which the filter operates so as to ameliorate the biasing of the filtering operation by the change in gain.

According to another, and related, aspect, the invention also provides a method of processing a signal that has been amplified under variable gain, comprising digitally filtering the signal values and adapting, when the gain changes, at least one signal value on which the digital filtering operates so as to ameliorate the biasing of the filtering operation by the change in gain.

Hence, the invention provides a more reliable way of applying a desired filtering characteristic to a digital signal.

In a preferred embodiment, the signal values involved in the filtering process are adapted by bit-shifting. Advantageously, this is simpler than generating adapted signal values by arithmetic.

In one embodiment, the variable gain is factored into two factors, the first factor being the highest exponent of two present in the gain and the second factor being such that when multiplied with the first factor, the result is the gain value. Then, the signal values can be divided by the second factor such that the only gain variations present in the signal values are variations in the exponent of the first factor, e.g. variations such as the first factor changing from $2^m$ to $2^{m+1}$. Advantageously, the filter need only then be able to cope with variations of this constrained kind. By then bit-shifting the signal values involved in the filtering process, it is possible to render the filtering operation insensitive to gain variations by a factor which is an exponent of two. Preferably, when bit-shifted, a signal value is displaced by a number of binary places corresponding to the numerical change in the exponent of the first factor.

In a preferred embodiment, the filter averages the signal values passing through it. Preferably, this averaging process is a weighted averaging process.

In a preferred embodiment, the filtered signal is a signal representing one of a noise signal and a wanted signal that is to be used for assessing the wanted signal relative to the noise signal (e.g. by calculating the ratio of the power in the wanted signal relative to the power in the noise signal).

By way of example only, an embodiment of the invention will now be described with reference to the accompanying figures, in which:

Figure 1 is a block diagram of a radio receiver; and

Figure 2 is a block diagram of the amplitude adaptive filter of Figure 1.

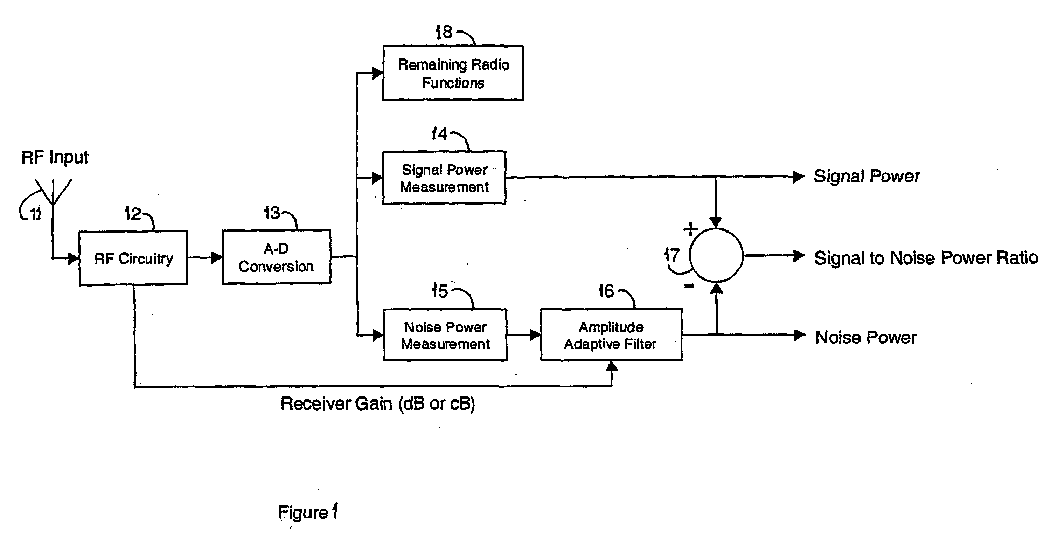

The radio receiver of Figure 1 comprises an antenna 11 for receiving transmitted wireless signals. Signals picked up by antenna 11 are supplied to radio frequency circuitry 12 which recovers a signal from amongst the signals received at antenna 11. The recovered signal is passed to A-D converter 13 for conversion to the digital domain. One of the roles of RF circuitry 12 is to amplify the recovered signal. This amplification is done using automatic gain control and accordingly the recovered signal sent to A-D converter 13 has been produced under a varying gain. The gain which the RF circuitry 12 can apply to the recovered signal can adopt one of a plurality of discrete values as directed by the automatic gain control process, which process operates in a known manner.

Downstream of A-D converter 13, the digital version of the recovered signal is supplied to the main processing unit 18 of the radio receiver, where the information contained in the recovered signal is used in its intended way. The radio receiver is also arranged to calculate the signal to noise power ratio of the recovered signal. For this purpose, the digital version of the recovered signal output by A-D converter 13 is supplied to each of a signal power measuring section 14 and to a noise power measuring section 15. The signal power measurement section 14 calculates the power present in a wanted component of the digital version of the recovered signal. The noise power measurement section 15 calculates the power present in an unwanted component (i.e. a noise component) of the digital version of the recovered signal. The wanted component is isolated by a known correlation process and is subtracted from the recovered signal to produce the noise component.

The signal indicative of the measured noise power (from measurement section 15) is supplied to amplitude adaptive filter 16 which averages the noise power signal. The filter 16 has a number of coefficients that serve as the weighting factors used in the averaging process. The amplitude adaptive filter 16 is supplied with the power gain values used in RF circuitry 12 to amplify the recovered signal, and the amplitude adaptive filter 16 uses these gain values (in a manner which will be described in more detail later) to ensure that the averaging process that it performs is not biased by any changes in the gain used to amplify the recovered signal.

The output of filter 16 is a signal indicative of the average power of the noise component. The output of measuring section 14 is a signal indicative of the power in the wanted component of the recovered signal. The signals from section 15 and filter 16 are supplied to subtractor 17 which subtracts the noise power signal from the wanted power signal. This subtraction produces a signal to noise power ratio, since at this stage the signal power signal and the noise power signal each represent the logarithm of measured power so that the action of the subtractor is equivalent to division. The signals indicative of wanted power, noise power and the signal to noise power ratio are supplied to other components of the radio receiver and used in the control of the radio receiver in a known manner.

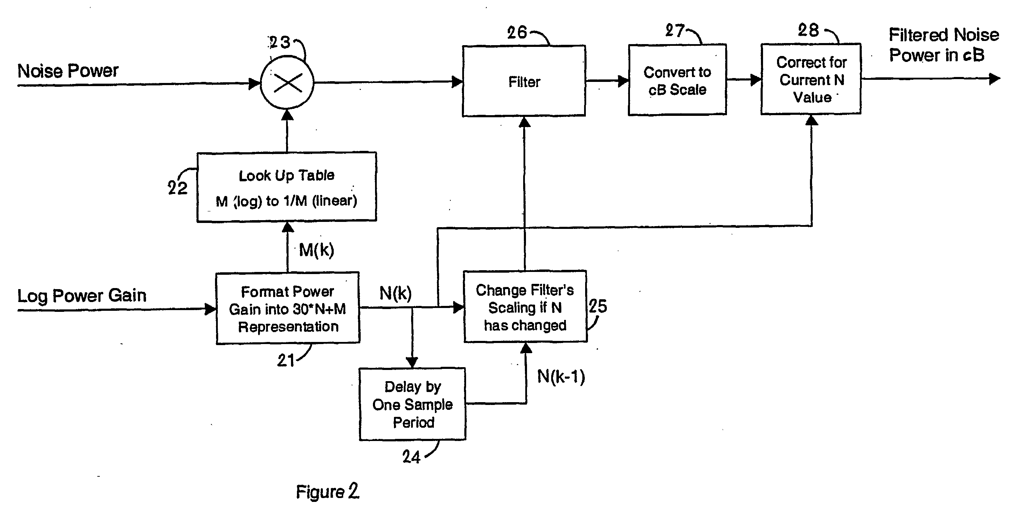

The construction of the amplitude adaptive filter 16 is illustrated in Figure 2. The noise power signal, in its raw form, is supplied as a stream of values $P_k$ (where k=1, 2, 3.....) from measuring section 15 to an input of multiplier 23. The power gain applied to the recovered signal is supplied in logarithmic format from RF circuitry 12 to formatting unit 21.

The logarithmic signal supplied to formatting unit 21 represents the receiver gain in centibels, cB (10cB = 1dB). The formatting unit 21 converts the centibel gain G, into a new representation which is the sum of two factors, M and 30N. Accordingly, G = M+30N. To convert the centibel gain into the new representation, the centibel gain G is divided by 30, and the integer part of the result is the value of N. Once N has been determined, M is determined from the equation M=G-30N.

As time progresses, the values, $P_k$, of the noise power signal pass through the amplitude adaptive filter 16, and $P_{k-1}$ is the preceding (in time) value of the noise power signal and $P_{k+1}$ is the succeeding (in time) value of the noise power signal. Accordingly, it is appropriate to apply the same nomenclature to the gain and refer to the logarithmic gain as $G_k$. However, it will be appreciated that $G_k$ will only vary relative to a neighbouring gain value (say $G_{k+1}$) if the gain is actually changed by the automatic gain control process in the RF circuitry 12. Similarly, the additive components of the gain representation produced by formatting unit 21 are more properly referred to as $M_k$ and $N_k$. Clearly, $M_k$ and $N_k$ will only change if $G_k$ changes. $N_k$ will only change when there is a change in the integer part of G÷30. It will be apparent to the reader that each time N increases by one, the linear gain (i.e. $10^{G_k}$, and not the logarithmic gain $G_k$) changes by a factor of approximately 2, that is, $10^{(30÷100)} \approx 2$. Conversely, decrementing N by 1 leads to a halving of the linear gain.

The value $M_k$ from formatting unit 21 is supplied to converter 22 which transforms this component of the gain to a linear value of

$$10^{\left(\frac{M_k}{100}\right)}.$$

Converter 22 then calculates the inverse of this linear value, i.e.

$$10^{-\left(\frac{M_k}{100}\right)}.$$

The value

$$10^{-\left(\frac{M_k}{100}\right)}$$

is supplied to the other input of multiplier 23. Accordingly, multiplier 23 divides $P_k$ by the linear value corresponding to $M_k$ to produce a scaled power value $P'_k$. The variation of the noise power values with changes in the linear gain has only been partially removed in that the linear gain remaining in the power values output by multiplier 23 may still vary by a factor which is an exponent of 2. For example, consider that there is a gain change such that $G_k$ is not equal to $G_{k+1}$. If $N_k = N_{k+1}$, then the gain residually present in the output of multiplier 23 does not change. If, on the other hand, $N_{k+1} \neq N_k$, then the residual gain present in $P'_{k+1}$ is a factor of $2^b$ (b is a positive or negative integer) different from the residual gain present in $P'_k$. In summary, it will be seen that variations in the gain have not been eliminated in the output of multiplier 23, but rather the gain in the $P'_k$ values has been restricted to take only values with ratios of $2^{N_k}$.

Returning now to formatting unit 21, the value $N_k$ is supplied to a delay unit 24, a comparison unit 25 and to a correction unit 28. The delay unit 24 delays the value of $N_k$ for one sample period of the digital signals (i.e. until $N_{k+1}$ is issued by formatting unit 21) and then presents $N_k$ to an input of the comparison unit 25. Thus, it will be seen that comparison unit 25 always compares consecutive values of N, e.g. $N_k$ and $N_{k-1}$. If the comparison unit detects a change in consecutive values of N, then it instructs a scaling of the signal values of $P'$ that are already in digital filter 26.

The digital filter 26 performs an averaging operation on the values of $P'$ received from multiplier 23. Digital filter 26 produces an output $P''_k$ in response to an input $P'_k$. $P''_k$ is produced by performing a weighted average on a group of consecutive values of $P'$. The filter coefficients provide the weighting factors in the weighted averaging process performed by filter 26.

Consider now the case where the gain G changes so as to affect N such that $N_{k+1} - N_k = b$, where b can take positive or negative integer values.

Upon the filter calculating $P''_{k+1}$, the values of $P'$ already within the filter 26 will initially need to be multiplied by a factor of $2^b$ (which is diminishing if b is negative) to ensure that the filtering process is not biased by the difference in the residual gain between $P'_{k+1}$ and the $P'$ values already in the filter. To achieve this multiplication, each of the values of $P'$ already within the filter are bit-shifted by a number of bits $|b|$ in the direction of increasing bit-significance if b is positive or, if b is negative, in the direction of decreasing bit significance. Hence, the modification of the $P'$ values is achieved without recourse to time consuming arithmetic.

The filtered power values $P''_k$ output by filter 26 are converted from linear values to logarithmic values on the centibel scale by scaling unit 27. The centibel $P''_k$ values are then supplied to corrector unit 28 which subtracts $N_k$ from $P''_k$, which is equivalent to dividing the linear value corresponding to $P''_k$ by the linear gain factor corresponding to $N_k$. The output of corrector unit 28 is a filtered noise power in centibels that is insensitive to changes in the power gain used to amplify the recovered signal in the RF circuitry 12.

Whilst the invention has been described in the context of a signal which is a train of power values, it will be appreciated by the skilled person that the signal values could, equally, represent (for example) the amplitude or level of a signal.

## Claims

1. Signal processing apparatus for operating on a signal that has been amplified under variable gain, the apparatus comprising a digital filter (26) for filtering the signal values and **characterised by** further comprising adapting means (25) for adapting, when the gain changes, at least one signal value on which the filter operates so as to ameliorate the biasing of the filtering operation by the change in gain.

2. Apparatus according to claim 1, wherein the adapting means is arranged to bit-shift said at least one signal value to adapt said at least one signal value.

3. Apparatus according to claim 1 or 2, further comprising means (21) for factorising the gain into two factors, the first factor being the highest power of 2 present in the gain and the second factor being such that when multiplied with the first factor the result is the gain value.

4. Apparatus according to claim 3, wherein the adapting means is arranged to change said at least one signal value upon detecting a change in the first factor.

5. Apparatus according to claim 4, wherein the adapting means is arranged to bit-shift said at least one signal value by a number of bits corresponding to the numerical change in the exponent of the first factor.

6. Apparatus according to any one of claims 3 to 5, further comprising first scaling means (23) for scaling the signal values by the second factor before they reach the filter.

7. Apparatus according to any one of claims 3 to 6, further comprising second scaling means (28) for scaling the signal values by the first factor after they have passed through the filter.

8. Apparatus according to any preceding claim wherein the gain values are logarithmic.

9. Apparatus according to any preceding claim wherein the filter is arranged to average signal values passing through it.

10. Apparatus according to any preceding claim wherein the signal is a noise signal or noise component.

11. Apparatus according to any preceding claim, further comprising means (17) for assessing a wanted signal relative to a noise signal, wherein the filtered signal values provide one of the wanted signal and the noise signal.

12. A method of processing a signal that has been amplified under variable gain, comprising digitally filtering the signal values and **characterised by** further comprising adapting, when the gain changes, at least one signal value on which the digital filtering operates so as to ameliorate the biasing of the filtering operation by the change in gain.

13. A method according to claim 12, wherein adapting said at least one signal value comprises bit-shifting said at least one signal value.

14. A method according to claim 12 or 13, further comprising factorising the gain into two factors, the first factor being the highest power of 2 present in the gain and the second being such that when multiplied with the first factor the result is the gain.

15. A method according to claim 14, wherein said at least one signal value is changed upon detecting a change in the first factor.

16. A method according to claim 15, wherein changes to the said at least one signal value are implemented by bit-shifting said at least one signal value by a number of bits corresponding to the numerical change in the exponent of first factor.

**17.** A method according to any one of claims 14 to 16, further comprising scaling the signal values by the second factor before they are filtered.

**18.** A method according to any one of claims 14 to 17, further comprising scaling the signal values by the first factor after they have been filtered.

**19.** A method according to any one of claims 12 to 18, wherein the gain is logarithmic.

**20.** A method according to any one of claims 12 to 19, wherein the filtering operation averages the power values.

**21.** A method according to any one of claims 12 to 20, wherein the signal is a noise signal or noise component.

**22.** A method according to any one of claims 12 to 21, comprising assessing a wanted signal relative to a noise signal, wherein the filtered signal values provide one of the wanted signal and the noise signal.

**23.** A program which when executed on data processing apparatus performs the method of any one of claims 12 to 22.

**Patentansprüche**

**1.** Signalverarbeitungs-Vorrichtung zur Bearbeitung eines Signals, das mit variabler Verstärkung verstärkt worden ist, welche Vorrichtung einen Digitalfilter (25) zur Filterung der Signalwerte umfasst, **gekennzeichnet durch** eine Anpassungseinrichtung (25) zur Anpassung zumindest eines Signalwerts, der vom Filter bearbeitet wird, bei Veränderung der Verstärkung, zur Verbesserung der Vorspannung des Filterungsvorgangs **durch** die Veränderung der Verstärkung.

**2.** Vorrichtung gemäß Anspruch 1, bei welcher die Anpassungseinrichtung dazu angeordnet ist, zur Anpassung des zumindest einen Signalwerts eine Bitverschiebung des zumindest einen Signalwerts vorzunehmen.

**3.** Vorrichtung gemäß Anspruch 1 oder 2, **gekennzeichnet durch** eine Einrichtung (21) zur Faktorisierung der Verstärkung in zwei Faktoren, von denen der erste Faktor die höchste in der Verstärkung vorhandene Potenz von 2 ist und der zweite Faktor so gewählt ist, dass er bei einer Multiplikation mit dem ersten Faktor den Verstärkungswert ergibt.

**4.** Vorrichtung gemäß Anspruch 3, bei welcher die Anpassungseinrichtung dazu vorgesehen ist, den zumindest einen Signalwert bei einer Feststellung einer Veränderung des ersten Faktors zu verändern.

**5.** Vorrichtung gemäß Anspruch 4, bei welcher die Anpassungseinrichtung dazu vorgesehen ist, eine Bitverschiebung des zumindest einen Signalwerts um eine Anzahl von Bits vorzunehmen, die der numerischen Änderung des Exponenten des ersten Faktors entspricht.

**6.** Vorrichtung gemäß einem der Ansprüche 3 bis 5, ferner umfassend eine erste Skaliereinrichtung (23) zur Skalierung der Signalwerte um den zweiten Faktor vor Erreichen des Filters.

**7.** Vorrichtung gemäß einem der Ansprüche 3 bis 6, ferner umfassend eine zweite Skaliereinrichtung (28) zur Skalierung der Signalwerte um den ersten Faktor, nachdem sie den Filter passiert haben.

**8.** Vorrichtung gemäß einem der vorhergehenden Ansprüche, bei welcher die Verstärkungswerte logarithmisch sind.

**9.** Vorrichtung gemäß einem der vorhergehenden Ansprüche, bei welcher der Filter dazu vorgesehen ist, die Signalwerte zu mitteln, bevor sie den Filter passieren.

**10.** Vorrichtung gemäß einem der vorhergehenden Ansprüche, bei welcher das Signal ein Rauschsignal oder eine Rauschkomponente ist.

**11.** Vorrichtung gemäß einem der vorhergehenden Ansprüche, ferner umfassend eine Einrichtung (17) zur Abschätzung eines gewünschten Signals bezüglich eines Rauschsignals, wobei die gefilterten Signalwerte entweder das gewünschte Signal oder das Rauschsignal vorgeben.

**12.** Verfahren zur Verarbeitung eines Signals, das mit variabler Verstärkung verstärkt worden ist, umfassend eine digitale Filterung der Signalwerte, **dadurch gekennzeichnet, dass** bei einer Veränderung der Verstärkung zumindest ein Signalwert angepasst wird, an welchem die digitale Filterung durchgeführt wird, zur Verbesserung der Vorspannung des Filterungsvorgangs durch Veränderung der Verstärkung.

**13.** Verfahren gemäß Anspruch 5, bei welchem die Anpassung des zumindest einen Signalwerts eine Bitverschiebung des zumindest einen Signalwerts umfasst.

**14.** Verfahren gemäß Anspruch 12 oder 13, bei welchem ferner die Verstärkung in zwei Faktoren faktorisiert wird, von denen der erste Faktor die höchste in der Verstärkung vorhandene Potenz von 2 ist und der zweite Faktor bei einer Multiplikation mit dem ersten Faktor die Verstärkung ergibt.

15. Verfahren gemäß Anspruch 14, bei welchem der zumindest eine Signalwert bei Feststellung einer Veränderung des ersten Faktors verändert wird.

16. Verfahren gemäß Anspruch 15, bei welchem Veränderungen des zumindest einen Signalwerts durch Bitverschiebung des zumindest einen Signalwerts um eine Anzahl von Bits entsprechend der numerischen Veränderung des Exponenten des ersten Faktors implementiert werden.

17. Verfahren gemäß einem der Ansprüche 14 bis 16. ferner umfassend eine Skalierung der Signalwerte durch den zweiten Faktor vor der Filterung.

18. Verfahren gemäß einem der Ansprüche 14 bis 17, ferner umfassend eine Skalierung der Signalwerte durch den ersten Faktor nach der Filterung.

19. Verfahren gemäß einem der Ansprüche 12 bis 18, bei welchem die Verstärkung logarithmisch ist.

20. Verfahren gemäß einem der Ansprüche 12 bis 19, bei welchem der Filterungsvorgang die Leistungswerte mittelt.

21. Verfahren gemäß einem der Ansprüche 12 bis 20, bei welchem das Signal ein Rauschsignal oder eine Rauschkomponente ist.

22. Verfahren gemäß einem der Ansprüche 12 bis 21. umfassend eine Abschätzung eines gewünschten Signals bezüglich eines Rauschsignals, wobei die gefilterten Signalwerte entweder das gewünschte Signal oder das Rauschsignal vorgeben.

23. Programm, das bei Ausführung in einer Datenverarbeitungsanlage das Verfahren gemäß einem der Ansprüche 12 bis 22 durchführt.

**Revendications**

1. Dispositif de traitement de signal destiné à travailler sur un signal qui a été amplifié sous gain variable, le dispositif comprenant un filtre numérique (26) pour filtrer les valeurs de signal et **caractérisé en ce qu'**il comprend de plus un moyen d'adaptation (25) pour adapter, lorsque le gain change, au moins une valeur du signal sur lequel le filtre travaille de façon à améliorer la polarisation de l'opération de filtrage par le changement de gain.

2. Dispositif selon la revendication 1, dans lequel le moyen d'adaptation est agencé pour convertir en bits ladite ou chaque valeur du signal pour adapter ladite ou chaque valeur du signal.

3. Dispositif selon la revendication 1 ou 2, comprenant de plus un moyen (21) pour factoriser le gain en deux facteurs, le premier facteur étant la plus haute puissance de 2 présente dans le gain et le second facteur étant tel que lorsqu'il est multiplié par le premier facteur, le résultat est la valeur du gain.

4. Dispositif selon la revendication 3, dans lequel le moyen d'adaptation est agencé de façon à modifier ladite ou chaque valeur de signal sur détection d'un changement du premier facteur.

5. Dispositif selon la revendication 4, dans lequel le moyen d'adaptation est agencé de façon à convertir en bits ladite ou chaque valeur de signal par un nombre de bits correspondant au changement numérique de l'exposant du premier facteur.

6. Dispositif selon l'une quelconque des revendications 3 à 5, comprenant en outre un premier moyen de cadrage (23) pour cadrer les valeurs de signal par le second facteur avant qu'elles n'aient atteint le filtre.

7. Dispositif selon l'une quelconque des revendications 3 à 6, comprenant en outre un second moyen de cadrage (28) pour cadrer les valeurs de signal par le premier facteur après qu'elles soient passées à travers le filtre.

8. Dispositif selon l'une quelconque des revendications précédentes, dans lequel les valeurs du gain sont logarithmiques.

9. Dispositif selon l'une quelconque des revendications précédentes, dans lequel le filtre est agencé pour faire la moyenne des valeurs de signal le traversant.

10. Dispositif selon l'une quelconque des revendications précédentes, dans lequel le signal est un signal de bruit ou une composante du bruit.

11. Dispositif selon l'une quelconque des revendications précédentes, comprenant en outre un moyen (17) pour évaluer un signal attendu par rapport à un signal de bruit, dans lequel les valeurs de signal filtrées donnent soit le signal attendu, soit le signal de bruit.

12. Procédé de traitement d'un signal qui a été amplifié sous gain variable, comprenant un filtrage numérique des valeurs de signal et **caractérisé en ce qu'**il comprend de plus une adaptation, lorsque le gain change, d'au moins une valeur de signal sur laquelle le filtrage numérique travaille de façon à améliorer la polarisation de l'opération de filtrage par le changement de gain.

13. Procédé selon la revendication 12, dans lequel l'adaptation à ladite ou chaque valeur de signal comprend la conversion en bits de ladite ou chaque valeur de signal.

14. Procédé selon la revendication 12 ou 13, comprenant en outre la factorisation du gain en deux facteurs, le premier facteur étant la plus haute puissance de 2 présente dans le gain et le second étant tel que lorsqu'il est multiplié par le premier facteur, le résultat est le gain.

15. Procédé selon la revendication 14, dans lequel ladite ou chaque valeur de signal est modifiée sur détection d'une modification du premier facteur.

16. Procédé selon la revendication 15, dans lequel des changements de ladite ou chaque valeur de signal sont mises en oeuvre par une conversion en bits de ladite au moins une valeur de signal par un nombre de bits correspondant au changement numérique de l'exposant du premier facteur.

17. Procédé selon l'une quelconque des revendications 14 à 16, comprenant en outre le cadrage des valeurs de signal par le second facteur avant qu'elles ne soient filtrées.

18. Procédé selon l'une quelconque des revendications 14 à 17, comprenant en outre le cadrage des valeurs de signal par le premier facteur après qu'elles ont été filtrées.

19. Procédé selon l'une quelconque des revendications 12 à 18, dans lequel le gain est logarithmique.

20. Procédé selon l'une quelconque des revendications 12 à 19, dans lequel l'opération de filtrage fait la moyenne des valeurs de puissance.

21. Procédé selon l'une quelconque des revendications 12 à 20, dans lequel le signal est un signal de bruit ou une composante du bruit.

22. Procédé selon l'une quelconque des revendications 12 à 21, comprenant en outre l'estimation d'un signal recherché par rapport à un signal de bruit , dans lequel les valeurs de signal filtrées donnent soit le signal recherché, soit le signal de bruit.

23. Programme qui, lorsqu'il est exécuté sur le dispositif de traitement des données, réalise le procédé de l'une quelconque des revendications 12 à 22.

Figure 1

Figure 2

EP 1 360 773 B1